# EUROPEAN PATENT APPLICATION

(11) **EP 4 694 174 A1**
(43) Date of publication of application: **11.02.2026**
(21) Application number: 24779754.1
(22) Date of filing: 19.03.2024
(51) Int. Cl.: H04N 25/77, H01L 27/146, H04N 25/79

(54) **OPTICAL DETECTION DEVICE AND ELECTRONIC APPARATUS**

(30) Priority: 24.03.2023 JP 2023048562
(71) Applicant: Sony Semiconductor Solutions Corporation, Atsugi-shi, Kanagawa 243-0014 (JP)
(72) Inventor: KUMAGAI Yoshimichi, Atsugi-shi, Kanagawa 243-0014 (JP); BANDO Masashi, Atsugi-shi, Kanagawa 243-0014 (JP); AKIYAMA Shunya, Atsugi-shi, Kanagawa 243-0014 (JP); SHIMADA Hiroki, Atsugi-shi, Kanagawa 243-0014 (JP); OHURA Masashi, Kikuchi-gun, Kumamoto 869-1102 (JP); WATANABE Daiki, Atsugi-shi, Kanagawa 243-0014 (JP); MATSUMOTO Naoyuki, Atsugi-shi, Kanagawa 243-0014 (JP)
(74) Representative: Müller Hoffmann & Partner
(86) International application number: PCT/JP2024/010783
(87) International publication number: WO 2024/203629

(57) **Abstract**

To achieve high resolution and improve image quality of a captured image.

A photodetection device includes: a plurality of pixels each of which accumulates a charge corresponding to a light amount of incident light; a plurality of first pixel circuits each of which includes a plurality of capacitive elements that holds a voltage signal corresponding to a charge accumulated in the plurality of pixels at the same timing; a plurality of second pixel circuits that is shared by two or more of the first pixel circuits among the plurality of first pixel circuits and sequentially reads out charges held in two or more of the capacitive elements in the two or more of the first pixel circuits to generate a pixel signal; a logic circuit that performs a signal process on the plurality of pixel signals generated in the plurality of second pixel circuits; a first substrate on which the plurality of pixels is arranged; a second substrate which is laminated on the first substrate and on which the plurality of first pixel circuits and the plurality of second pixel circuits are arranged; and a third substrate which is laminated on the second substrate and on which the logic circuit is arranged.

## Description

### TECHNICAL FIELD

The present disclosure relates to a photodetection device and an electronic device.

### BACKGROUND ART

A rolling shutter type imaging apparatus that starts exposure while shifting time in units of pixel rows has a problem that a moving object image included in a captured image is distorted and captured. Therefore, a global shutter type imaging apparatus that simultaneously starts exposure in all pixels has been proposed (see Patent Document 1).

### CITATION LIST

### PATENT DOCUMENT

Patent Document 1: WO 2021/215105 A

### SUMMARY OF THE INVENTION

### PROBLEMS TO BE SOLVED BY THE INVENTION

In the global shutter method, it is necessary to provide a charge holding unit for holding an accumulated charge of a photoelectric conversion element of each pixel in each pixel, and the pixel size increases, which hinders high resolution. In addition, it is necessary to devise so as not to be affected by noise when the charge holding unit holds the accumulated charge of the photoelectric conversion element.

Therefore, the present disclosure provides a photodetection device and an electronic device capable of achieving high resolution and improving image quality of a captured image.

### SOLUTIONS TO PROBLEMS

In order to solve the above problem, according to the present disclosure, a photodetection device includes:
a plurality of pixels each of which accumulates a charge corresponding to a light amount of incident light;
a plurality of first pixel circuits each of which includes a plurality of capacitive elements that holds a voltage signal corresponding to a charge accumulated in the plurality of pixels at the same timing;
a plurality of second pixel circuits that is shared by two or more of the first pixel circuits among the plurality of first pixel circuits and sequentially reads out charges held in two or more of the capacitive elements in the two or more of the first pixel circuits to generate a pixel signal;
a logic circuit that performs a signal process on a plurality of the pixel signals generated in the plurality of second pixel circuits;
a first substrate on which the plurality of pixels is arranged;
a second substrate which is laminated on the first substrate and on which the plurality of first pixel circuits and the plurality of second pixel circuits are arranged; and
a third substrate which is laminated on the second substrate and on which the logic circuit is arranged.

A first wiring layer connected to the plurality of pixels in the first substrate and a second wiring layer connected to the plurality of first pixel circuits and the plurality of second pixel circuits in the second substrate may be arranged to face each other, and
the second wiring layer in the second substrate and a third wiring layer connected to the logic circuit in the third substrate may be arranged with the second substrate interposed therebetween.

The first substrate may include a plurality of first metal pads bonded to the first wiring layer, and
the second substrate may include a plurality of second metal pads bonded to the plurality of first metal pads and bonded to the second wiring layer.

The second substrate may include:
a semiconductor layer arranged to face the third substrate;
a plurality of first vias arranged so as to penetrate the semiconductor layer from the plurality of second pixel circuits; and
a plurality of third metal pads bonded to ends of the plurality of first vias, respectively, and
the third substrate may include a plurality of fourth metal pads bonded to the plurality of third metal pads.

The plurality of first vias may be connected to a plurality of signal lines for transmitting the plurality of pixel signals generated by the plurality of second pixel circuits to the logic circuit.

The plurality of first vias may be arranged over an entire region of the second substrate.

The second substrate may include a plurality of signal lines that transmits the plurality of pixel signals generated by the plurality of second pixel circuits,
the plurality of signal lines may be arranged in a first direction of the second substrate and each extend in a second direction intersecting the first direction,
the logic circuit may include an analog-digital converter that is arranged in a central portion of the third substrate in the second direction and performs analog-digital conversion of the pixel signals, and
at least a part of the plurality of first vias may be arranged in a central portion of the second substrate in the second direction in accordance with an arrangement region of the analog-digital converter in the third substrate and is connected to the plurality of signal lines.

The plurality of first vias may be arranged over an entire region of the second substrate, and
a first via arranged at a position other than the central portion of the second substrate in the second direction may be a dummy via that does not transmit a signal.

The plurality of first vias may be arranged one by one for each of the two or more pixels, and
the third metal pad and the fourth metal pad may be provided for each of the two or more pixels.

The second substrate may include a first peripheral circuit arranged in a region not overlapping the plurality of pixels in a plan view of the first substrate and the second substrate.

The first substrate may include a second peripheral circuit arranged in a region where the plurality of pixels is not arranged.

Each of the plurality of pixels may include:
a photoelectric conversion element that accumulates a charge corresponding to a light amount of incident light;
a first transistor that switches whether or not to transfer the accumulated charge of the photoelectric conversion element to a first floating diffusion region;
a second transistor that switches whether or not to initialize the charge of the first floating diffusion region; and
a first source follower circuit that generates a voltage signal corresponding to the charge of the first floating diffusion region,
each of the plurality of first pixel circuits may include:
   a first capacitive element that holds a voltage signal output from the first source follower circuit in a state where the charge of the first floating diffusion region of the corresponding pixel is initialized;
   a second capacitive element that holds a voltage signal output from the first source follower circuit in a state where the accumulated charge of the photoelectric conversion element is transferred to the first floating diffusion region of the corresponding pixel;
   a third transistor that switches whether or not to transfer a charge held in the first capacitive element to a second floating diffusion region shared by the two or more first pixel circuits; and
   a fourth transistor that switches whether or not to transfer a charge held in the second capacitive element to the second floating diffusion region, and
   each of the plurality of second pixel circuits may include:
      a fifth transistor that switches whether or not to initialize the charge of the second floating diffusion region; and
      a second source follower circuit that generates a pixel signal according to the charge of the second floating diffusion region.

Each of the plurality of pixels may include:
a third capacitance element that accumulates a part of the accumulated charge of the photoelectric conversion element; and
a sixth transistor that switches whether or not to accumulate a part of the accumulated charge of the photoelectric conversion element in the third capacitance element.

Each of the plurality of pixels may include a seventh transistor that switches whether or not to discharge the accumulated charge of the photoelectric conversion element.

The photodetection device may further include:
a fourth capacitive element that holds the accumulated charge of the photoelectric conversion element discharged via the seventh transistor; and
an eighth transistor that switches whether or not to transfer the charge held in the fourth capacitive element to the first floating diffusion region.

The fourth capacitive element may be arranged on the first substrate.

Each of the plurality of first pixel circuits may include
a ninth transistor and a tenth transistor cascode-connected between an output node of the first source follower circuit and a reference voltage node, and
the ninth transistor and the tenth transistor may be turned on at different timings to precharge the first capacitive element and the second capacitive element.

The photodetection device further includes:
a plurality of first holding circuits each including the first capacitive element and the third transistor and connected in parallel; and
a plurality of second holding circuits each including the second capacitive element and the fourth transistor and connected in parallel.

The photodetection device may further include a substrate contact that supplies a reference potential to at least one of the first substrate, the second substrate, or the third substrate.

According to the present disclosure, there is provided an electronic device including:
a photodetection device that generates an image according to a light amount of incident light; and
a processing unit that processes the image,
the photodetection device including:
   a plurality of pixels each of which accumulates a charge corresponding to a light amount of incident light;
   a plurality of first pixel circuits each of which includes a plurality of capacitive elements that holds a voltage signal corresponding to a charge accumulated in the plurality of pixels at the same timing;
   a plurality of second pixel circuits that is shared by two or more of the first pixel circuits among the plurality of first pixel circuits and sequentially reads out charges held in two or more of the capacitive elements in the two or more of the first pixel circuits to generate a pixel signal;
   a logic circuit that performs a signal process on a plurality of the pixel signals generated in the plurality of second pixel circuits;
   a first substrate on which the plurality of pixels is arranged;
   a second substrate which is laminated on the first substrate and on which the plurality of first pixel circuits and the plurality of second pixel circuits are arranged; and
   a third substrate which is laminated on the second substrate and on which the logic circuit is arranged.

### BRIEF DESCRIPTION OF DRAWINGS

Fig. 1 is a block diagram of an electronic device according to a first embodiment of the present disclosure.
Fig. 2 is a block diagram illustrating a schematic configuration of a photodetection device according to the embodiment.
Fig. 3 is a circuit diagram of a pixel and a pixel circuit in a pixel array unit.
Fig. 4 is a circuit diagram illustrating an example in which four pixels and four first pixel circuits share one second pixel circuit.
Fig. 5 is a circuit diagram illustrating an example in which a second pixel circuit is shared by a total of two pixels including one pixel in a first direction and two pixels in a second direction.
Fig. 6 is a cross-sectional view illustrating a cross-sectional structure of the photodetection device according to the embodiment.
Fig. 7 is a cross-sectional view illustrating a first example of a cross-sectional structure of a peripheral circuit of a pixel.
Fig. 8 is a cross-sectional view illustrating a second example of a cross-sectional structure of a peripheral circuit of a pixel.
Fig. 9 is a plan layout diagram for 2×2 pixels of a first substrate in a case where four pixels and four first pixel circuits share one second pixel circuit.
Fig. 10 is a plan layout diagram of a unit pixel group region for 2×2 pixels of a second substrate laminated on the first substrate of Fig. 8.
Fig. 11 is a plan layout diagram illustrating an example of bonding positions of a first metal pad and a second metal pad and arrangement positions of TSVs on a second substrate.
Fig. 12 is a schematic plan layout diagram illustrating a first example of arrangement positions of the TSVs.
Fig. 13 is a schematic plan layout diagram illustrating a second example of the arrangement positions of the TSVs.
Fig. 14 is a schematic plan layout diagram illustrating a third example of the arrangement positions of the TSVs.
Fig. 15 is a circuit diagram illustrating a modification of the pixel and the first pixel circuit of Fig. 3.
Fig. 16 is a plan layout diagram of the first substrate corresponding to Fig. 15.
Fig. 17 is a plan layout diagram of a second substrate corresponding to Fig. 15.
Fig. 18 is a circuit diagram of a pixel, a first pixel circuit, and a second pixel circuit according to a first modification.
Fig. 19 is a circuit diagram of a pixel, a first pixel circuit, and a second pixel circuit according to a second modification.
Fig. 20 is a circuit diagram of a pixel, a first pixel circuit, and a second pixel circuit according to a third modification.
Fig. 21 is a circuit diagram of a pixel, a first pixel circuit, and a second pixel circuit according to a fourth modification.
Fig. 22 is a circuit diagram of a pixel, a first pixel circuit, and a second pixel circuit according to a fifth modification.
Fig. 23 is a block diagram illustrating an example of a schematic configuration of a vehicle control system.
Fig. 24 is an explanatory diagram illustrating an example of installation positions of a vehicle exterior information detection unit and an imaging unit.
Fig. 25 is a view illustrating an example of a schematic configuration of an endoscopic surgery system.
Fig. 26 is a block diagram illustrating an example of a functional configuration of a camera head and a camera control unit (CCU).

### MODE FOR CARRYING OUT THE INVENTION

Hereinafter, embodiments of a photodetection device and an electronic device will be described with reference to the drawings. Hereinafter, main components of the photodetection device and the electronic device will be mainly described, but the photodetection device and the electronic device may have components and functions that are not illustrated or described. The following description is not intended to exclude components and functions that are not illustrated or described.

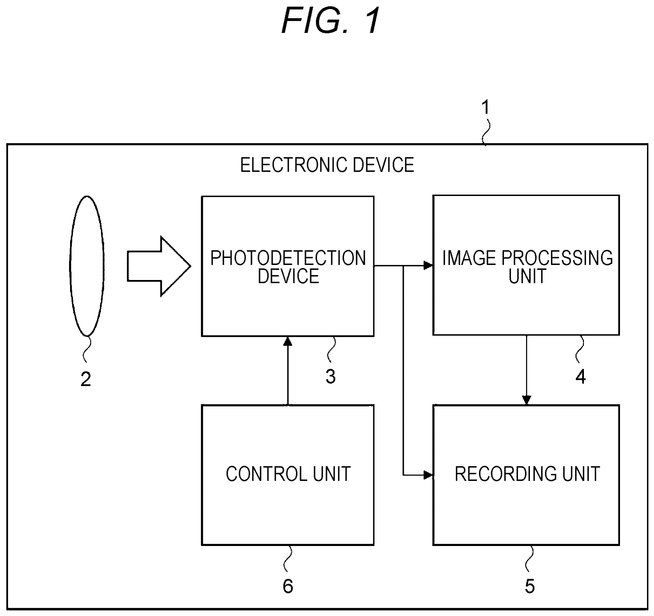

Fig. 1 is a block diagram of an electronic device 1 according to a first embodiment of the present disclosure. The electronic device 1 has a function of generating an image according to luminance of incident light. The electronic device 1 of Fig. 1 includes an imaging lens 2, a photodetection device 3, an image processing unit 4, a recording unit 5, and a control unit 6. The electronic device 1 can be applied to, for example, a surveillance camera, a camera mounted on an industrial robot, a camera for general use, or the like, but the specific application and configuration of the electronic device 1 are arbitrary.

The imaging lens 2 condenses incident light and guides the light to the photodetection device 3. The photodetection device 3 images incident light. The photodetection device 3 has a function of photoelectrically converting light in a predetermined wavelength range such as visible light or infrared light to generate a captured image. The captured image generated by the photodetection device 3 is sent to the image processing unit 4 and the recording unit 5.

The image processing unit 4 executes a predetermined image process such as color or luminance adjustment, image compression, image recognition, tracking, or analysis on the captured image. The image processed by the image processing unit 4 is output to, for example, the recording unit 5.

The recording unit 5 records the image output from the photodetection device 3 or the image processing unit 4. The recording unit 5 may be arranged in a server or the like connected via a network. In the electronic device 1 according to the present embodiment, at least one of the image processing unit 4 and the recording unit 5 of Fig. 1 can be omitted.

The control unit 6 controls the operation of the photodetection device 3. Although not clearly illustrated in Fig. 1, the control unit 6 may control the image processing unit 4 and the recording unit 5.

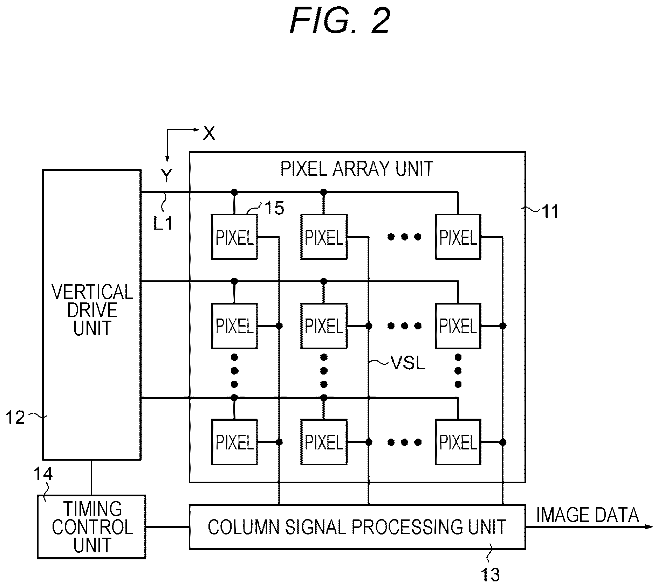

Fig. 2 is a block diagram illustrating a schematic configuration of the photodetection device 3 according to the embodiment. As illustrated in Fig. 2, the photodetection device 3 according to the embodiment includes a pixel array unit 11, a vertical drive unit 12, a column signal processing unit 13, and a timing control unit 14.

The pixel array unit 11 includes a plurality of pixels 15 arranged in a first direction (for example, a row direction) X and a second direction (for example, a vertical direction) Y. Although not illustrated in Fig. 2, a pixel circuit is connected to each pixel 15. Detailed configurations of the pixel 15 and the pixel circuit will be described later.

The vertical drive unit 12 sequentially selects and drives each of a plurality of pixel groups (for example, pixel rows) arranged in a first direction X of the pixel array unit 11. More specifically, a plurality of row selection lines L1 is connected to the vertical drive unit 12. Each of the plurality of row selection lines L1 is used to drive a corresponding pixel row.

A vertical signal line VSL is connected to each of a plurality of pixel groups (for example, pixel columns) arranged in a second direction Y of the pixel array unit 11. Each vertical signal line VSL transmits a pixel signal generated by a pixel circuit connected to each pixel 15. The plurality of vertical signal lines VSL is connected to the column signal processing unit 13.

The column signal processing unit 13 performs analog-digital conversion on the pixel signal transmitted through each vertical signal line VSL to generate a digital pixel signal. The column signal processing unit 13 is controlled by a horizontal drive unit (not illustrated) and sequentially outputs digital pixel signals.

The timing control unit 14 controls the timings of the vertical drive unit 12 and the column signal processing unit 13.

As will be described later, the photodetection device 3 according to the embodiment is configured by laminating three semiconductor substrates (referred to as a first substrate, a second substrate, and a third substrate.). Each pixel 15 and the pixel circuit of the pixel array unit 11 are separately arranged on the first substrate and the second substrate. In the present specification, among the pixel 15 and the pixel circuit, one arranged on the first substrate is referred to as a pixel 15, and one arranged on the second substrate is referred to as a pixel circuit. However, a boundary between the pixel 15 and the pixel circuit is not clearly defined, and in the present specification, the pixel 15 and the pixel circuit may be collectively referred to as a pixel 15.

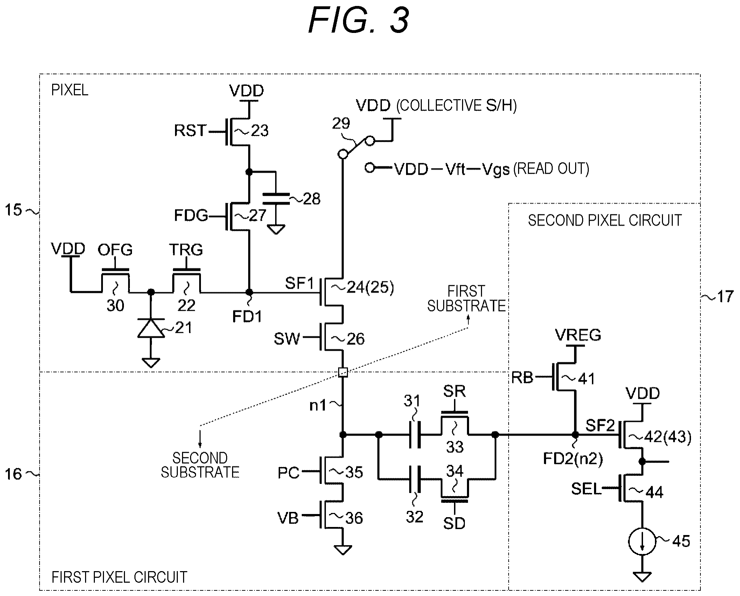

Fig. 3 is a circuit diagram of the pixel 15 and the pixel circuit in the pixel array unit 11. In the present embodiment, a pixel sharing method in which a part of a pixel circuit connected to the pixel 15 is shared by a plurality of pixels 15 is adopted. In the present specification, in the pixel circuit, a circuit portion provided for each pixel 15 is referred to as a first pixel circuit 16, and a circuit portion shared by the plurality of pixels 15 is referred to as a second pixel circuit 17.

As illustrated in Fig. 3, the pixel 15 includes a photoelectric conversion element 21, a transfer transistor 22, a first reset transistor 23, a first amplification transistor 25 constituting a first source follower circuit (SF1) 24, and a first selection transistor 26. Fig. 3 illustrates an example in which all the transistors in the pixel 15 and the pixel circuit are constituted by N-channel metal oxide semiconductor (NMOS) transistors, but at least some of the transistors may be constituted by P-channel MOS (PMOS) transistors.

The photoelectric conversion element 21 is, for example, a photodiode. The photoelectric conversion element 21 accumulates charges according to the light amount of incident light.

In the photoelectric conversion element 21, all the pixels 15 start exposure at the same timing. The transfer transistor 22 transfers the accumulated charges of the photoelectric conversion element 21 to a first floating diffusion region FD1 at the same timing in all the pixels 15. The first floating diffusion region FD1 is set to a reset state in which charges are discharged, or set to a state in which accumulated charges of the photoelectric conversion element 21, that is, signal charges are transferred. The transfer transistor 22 is turned on when the TRG signal is at a high level. As described above, the TRG signals of all pixels 15 transition to the high level at the same timing.

The first reset transistor 23 discharges the accumulated charges of the photoelectric conversion element 21 and the charges of the first floating diffusion region FD1 before the photoelectric conversion element 21 starts a photoelectric conversion operation (hereinafter, it may be referred to as an exposure operation). The first reset transistor 23 is turned on when the RST signal is at a high level.

In Fig. 3, a conversion efficiency switching transistor 27 and a charge holding unit 28 are arranged between the first reset transistor 23 and the first floating diffusion region FD1, but the conversion efficiency switching transistor 27 and the charge holding unit 28 can be omitted. The charge holding unit 28 is connected between the drain of the conversion efficiency switching transistor 27 and a reference voltage node (for example, a ground voltage node). A part of the accumulated charges of the photoelectric conversion element 21 is held in the charge holding unit 28 via the conversion efficiency switching transistor 27, so that more accumulated charges can be held, and the dynamic range can be expanded. The conversion efficiency switching transistor 27 is turned on when the FDG signal is at a high level, and causes the charge holding unit 28 to hold the accumulated charges in the photoelectric conversion element 21.

The first amplification transistor 25 constituting the first source follower circuit 24 generates a voltage signal corresponding to the accumulated charges in the first floating diffusion region FD1. When the first selection transistor 26 is turned on, the above-described voltage signal is sent to the first pixel circuit 16.

The drain of the first amplification transistor 25 may be connected to the power supply voltage node, or may be connected to a voltage switcher 29 as illustrated in Fig. 3. The voltage switcher 29 switches and connects the drain of the first amplification transistor 25 to either a first reference voltage node or a second reference voltage node. The voltage switcher 29 selects the first reference voltage node when holding a voltage signal corresponding to accumulated charges by photoelectric conversion or reset charges in a first capacitive element or a second capacitive element to be described later, and selects a second reference voltage node when reading a pixel signal from the second pixel circuit 17 to the vertical signal line VSL. The first reference voltage node has a higher voltage level than the second reference voltage node.

The first selection transistor 26 is turned on when the SW signal is at a high level. When the first selection transistor 26 is turned on, the voltage signal of the first floating diffusion region FD1 is supplied to the first pixel circuit 16. In the present specification, the source of the first selection transistor is referred to as an output node n1 of the pixel 15.

The pixel 15 may include a discharge transistor 30. The discharge transistor 30 is turned on when the OFG signal is at a high level, and discharges the charges overflowing from the photoelectric conversion element 21.

As illustrated in Fig. 3, the first pixel circuit 16 includes a first capacitive element 31, a second capacitive element 32, a first sampling transistor 33, and a second sampling transistor 34.

The first capacitive element 31 and the first sampling transistor 33 are connected in series between the output node n1 of the pixel 15 and a second floating diffusion region FD2. The second capacitive element 32 and the second sampling transistor 34 are connected in series between the output node n1 of the pixel 15 and the second floating diffusion region FD2.

The first capacitive element 31 holds a voltage signal in which the first floating diffusion region FD1 is in a reset state when the first sampling transistor 33 is on. The first sampling transistor 33 is turned on when the SR signal is at a high level. The second capacitive element 32 holds a voltage signal in a state where signal charges are accumulated in the first floating diffusion region FD1 when the second sampling transistor 34 is on. The second sampling transistor 34 is turned on when the SD signal is at a high level.

The first capacitive element 31 and the second capacitive element 32 are formed in, for example, a metal insulator metal (MIM) structure. For example, by forming irregularities in a part of the semiconductor layer and laminating a metal layer, an insulating layer, and a metal layer along the irregularity surface, the first capacitive element 31 and the second capacitive element 32 having the MIM structure can be formed by a semiconductor process. By increasing the number of irregularities, the surface area of the metal layer can be increased, and the capacity can be increased.

The first pixel circuit 16 has a current source connected between the output node n1 of the pixel 15 and a reference voltage node (for example, a ground voltage node). This current source can be configured by, for example, two cascode-connected transistors 35 and 36. A control signal PC is input to one gate of each of these transistors, and a control signal VB is input to the other gate. When the control signal PC becomes the high level, the transistor 35 is turned on, and when the control signal VB becomes the high level, the transistor 36 is turned on. The transistors 35 and 36 are used to precharge the first capacitive element 31 and the second capacitive element 32. By precharging the first capacitive element 31 and the second capacitive element 32, noise can be reduced.

As described above, in the present embodiment, the second pixel circuit 17 that is a part of the pixel circuit is shared by the plurality of pixels 15 and the plurality of first pixel circuits 16. The second pixel circuit 17 includes a second reset transistor 41, a second amplification transistor 43 constituting a second source follower circuit 42, a second selection transistor 44, and a current source 45.

The second reset transistor 41 is arranged between the reference voltage node VREG and the second floating diffusion region FD2. The second reset transistor 41 is turned on when the RB signal is at a high level, and initializes the charge of the second floating diffusion region FD2.

The gate of the second amplification transistor 43 constituting the second source follower circuit 42 is connected to the second floating diffusion region FD2, the drain thereof is connected to the reference voltage node VDD, and the source thereof is connected to the drain of the second selection transistor 44. The second source follower circuit 42 generates a pixel signal corresponding to the voltage level of the second floating diffusion region FD2 and supplies the pixel signal to the second selection transistor 44.

The second selection transistor 44 is turned on when the SEL signal is at a high level, and outputs the pixel signal generated by the second source follower circuit 42 to the vertical signal line VSL. The SEL signal is supplied by a row selection line connected to the vertical drive unit 12 of Fig. 1.

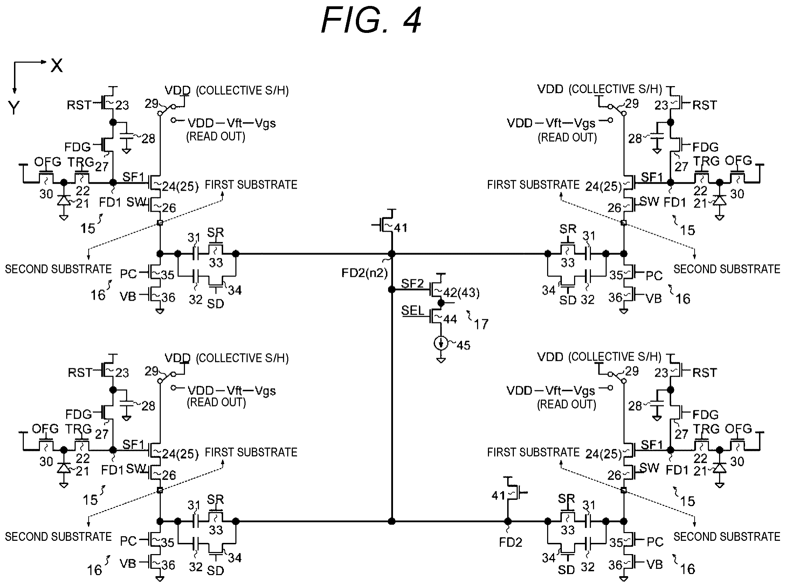

Fig. 4 is a circuit diagram illustrating an example in which four pixels 15 and four first pixel circuits 16 share one second pixel circuit 17. Fig. 4 illustrates an example in which the second pixel circuit 17 is shared by a total of four pixels 15 including two pixels 15 in the first direction X (row direction) and two pixels 15 in the second direction Y (vertical direction).

As illustrated in Fig. 4, the output nodes n2 of the four first pixel circuits 16 are connected to one second floating diffusion region FD2. Therefore, the second reset transistor 41, the second source follower circuit 42, and the second selection transistor 44 in the second pixel circuit 17 are shared by the four pixels 15 and the four first pixel circuits 16.

The four pixels 15, the four first pixel circuits 16, and the one second pixel circuit 17 illustrated in Fig. 4 are referred to as a unit pixel group region in the present specification. The unit pixel group region is arranged separately on the first substrate and the second substrate. In the example of Fig. 4, the photoelectric conversion element 21, the transfer transistor 22, the first reset transistor 23, the first source follower circuit 24, the first selection transistor 26, the conversion efficiency switching transistor 27, and the discharge transistor 30 constituting the pixel 15 are arranged on the first substrate. In addition, the first capacitive element 31, the first sampling transistor 33, the second capacitive element 32, and the second sampling transistor 34 constituting the first pixel circuit 16, the transistor groups 35 and 36 constituting the current source, and the second reset transistor 41, the second source follower circuit 42, and the second selection transistor 44 constituting the second pixel circuit 17 are arranged on the second substrate.

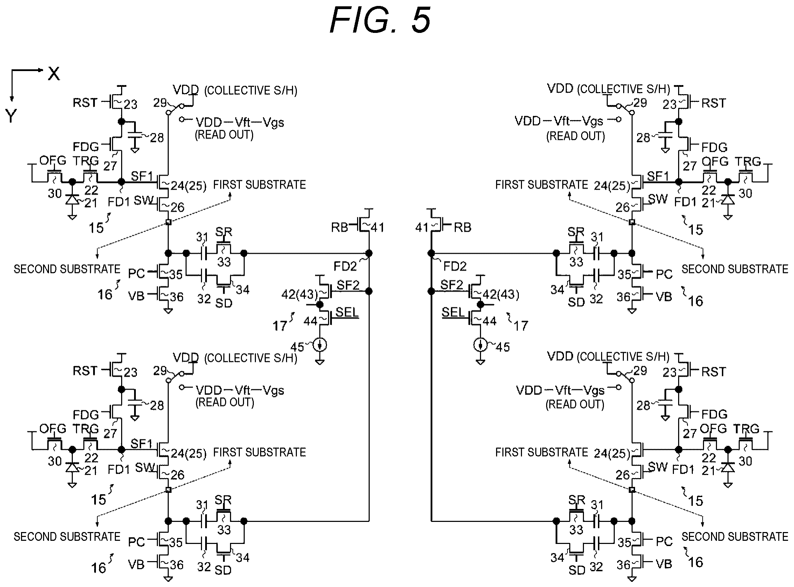

The unit sharing the second pixel circuit 17 is arbitrary, and various modifications can be taken. Fig. 5 is a circuit diagram illustrating an example in which the second pixel circuit 17 is shared by a total of two pixels 15 of one pixel 15 in the first direction X (horizontal direction) and two pixels 15 in the second direction Y (vertical direction). In the example of Fig. 5, the output nodes n2 of the two first pixel circuits 16 arranged adjacent to each other in the second direction Y are connected to each other and connected to one second floating diffusion region FD2. In the example of Fig. 5, two pixels 15, two first pixel circuits 16, and one second pixel circuit 17 are a unit pixel group region.

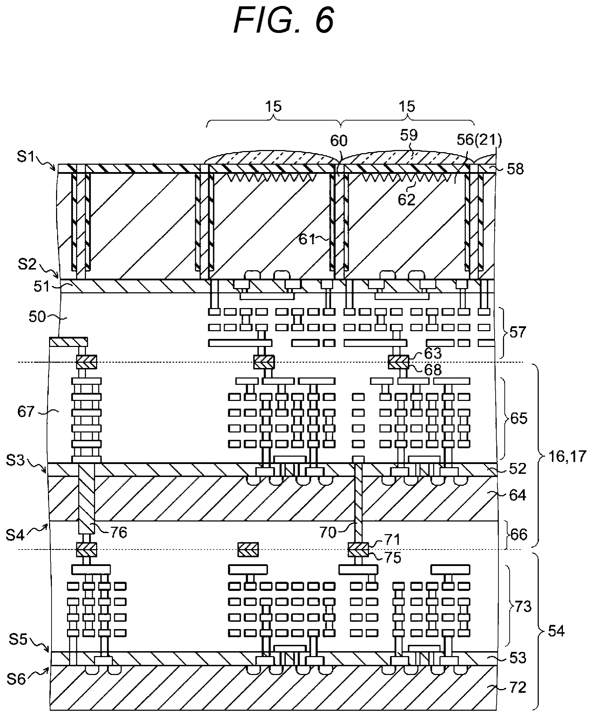

Fig. 6 is a cross-sectional view illustrating a cross-sectional structure of the photodetection device 3 according to the embodiment. As described above, the photodetection device 3 according to the embodiment has a laminated structure in which three semiconductor substrates (first to third substrates) 51 to 53 are laminated. The first substrate 51 is arranged on the light incident surface side, the second substrate 52 is laminated on the first substrate 51, and the third substrate 53 is laminated on the second substrate 52. The first substrate 51 and the second substrate 52 are bonded by metal pads to transmit and receive signals. More specifically, a plurality of first metal pads 63 provided on the first substrate 51 and a plurality of second metal pads 68 provided on the second substrate 52 are bonded, and each signal is transmitted and received through these metal pads.

A semiconductor layer (second semiconductor layer) 64 is arranged on a side of the second substrate 52 facing the third substrate 53, and a via 70 penetrating the semiconductor layer 64 is provided. This via penetrates a semiconductor layer (specifically, a silicon layer) and is thus called a through silicon via (TSV) 70. A plurality of third metal pads 71 arranged at the end of a TSV 70 on the third substrate 53 side and a plurality of fourth metal pads 75 for the third substrate 53 are bonded, and the second substrate 52 and the third substrate 53 transmit and receive signals via the metal pads 71 and 75.

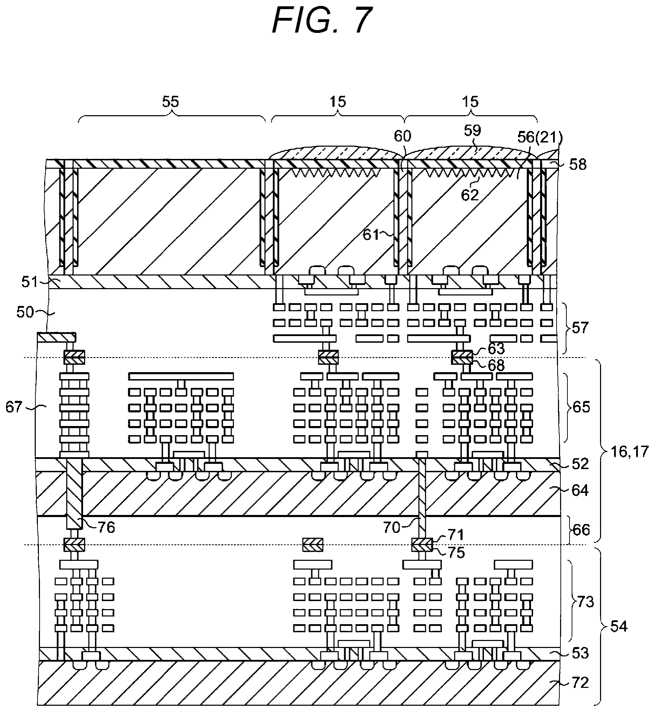

A plurality of pixels 15 is arranged on the first substrate 51. A plurality of first pixel circuits 16 and a plurality of second pixel circuits 17 are arranged on the second substrate 52. A logic circuit 54 is arranged on the third substrate 53. A peripheral circuit 55 (see Fig. 7) including the vertical drive unit 12, the column signal processing unit 13, and the timing control unit 14 other than the pixel array unit 11 illustrated in Fig. 2 is arranged, for example, in a free region of at least one of the first substrate 51 and the second substrate 52 as described later. At least a part of the peripheral circuit 55 may be arranged on the third substrate 53.

A first semiconductor layer 56, a first wiring layer 57, a color filter 58, an on-chip lens 59, and the like are arranged on the first substrate 51.

In the first semiconductor layer 56, the photoelectric conversion element 21 is arranged for each pixel 15. The photoelectric conversion element 21 is formed, for example, by arranging an n-type semiconductor region inside a p-type well region. In the boundary region of the pixel 15, a light shielding wall 60 that absorbs light from the adjacent pixel 15 is arranged. A fixed charge film 61 for preventing generation of dark current is arranged on the surface of the light shielding wall 60.

A first main surface S1 of the first semiconductor layer 56 is a light incident surface. The first main surface S1 has an uneven structure 62 for preventing reflection. The color filter 58 is arranged on the first main surface S1, and the on-chip lens 59 is arranged thereon. Note that the color filter 58 and the on-chip lens 59 are not essential components, and may be omitted.

On a second main surface S2 of the first semiconductor layer 56, some pixel transistors such as the transfer transistor 22 are arranged, and the first wiring layer 57 is arranged thereon (below in Fig. 6). The first wiring layer 57 has a laminated structure including a plurality of wiring layers and vias separated by a first insulating layer 50. The plurality of first metal pads 63 is arranged on an end surface of the first wiring layer 57 on the second substrate 52 side.

The second semiconductor layer 64, a second wiring layer 65, a third wiring layer 66, and the like are arranged on the second substrate 52. The second wiring layer 65 is arranged on a first main surface S3 side of the second semiconductor layer 64, and the third wiring layer 66 is arranged on a second main surface S4 of the second semiconductor layer 64. The first main surface S3 of the second semiconductor layer 64 is on the first substrate 51 side, and the second main surface S4 is on the third substrate 53 side.

The second wiring layer 65 has a laminated structure including a plurality of wiring layers and vias separated by a second insulating layer 67. The plurality of second metal pads 68 is arranged on the end surface of the second wiring layer 65 on the first substrate 51 side. Each of the plurality of second metal pads 68 is bonded to the corresponding first metal pad 63, and transmits and receives signals between the first substrate 51 and the second substrate 52. One first metal pad 63 and one second metal pad 68 are provided for each pixel 15, and transmit and receive a voltage signal at the output node n1 of the pixel 15 of Fig. 3.

In the second semiconductor layer 64, the transistors in the first pixel circuit 16 and the second pixel circuit 17 of Fig. 3 are arranged. A via extending from the second wiring layer 65 is connected to these transistors.

In addition, the TSV 70 extending toward the third substrate 53 through the second semiconductor layer 64 and the third wiring layer 66 is arranged. The TSV 70 is connected to the vertical signal line VSL of Fig. 3. The vertical signal line VSL is formed, for example, in the second wiring layer 65 of the second substrate 52. A plurality of third metal pads 71 is arranged at an end of the TSV 70 on the third substrate 53 side.

A third semiconductor layer 72, a fourth wiring layer 73, and the like are arranged on the third substrate 53. The fourth wiring layer 73 is arranged on a first main surface S5 of the third substrate 53, and the third semiconductor layer 72 is arranged on a second main surface S6 of the third substrate 53.

The fourth wiring layer 73 has a laminated structure including a plurality of wiring layers and vias separated by a third insulating layer 74. The plurality of fourth metal pads 75 is arranged on the end surface of the fourth wiring layer 73 on the second substrate 52 side. Each of the plurality of fourth metal pads 75 is bonded to the corresponding third metal pad 71, and transmits and receives signals between the second substrate 52 and the third substrate 53. The third metal pad 71 and the fourth metal pad 75 are provided by the number of the vertical signal lines VSL.

In this manner, the first wiring layer 57 and the second wiring layer 65 are arranged in a face to face (F to F) manner, and the first substrate 51 and the second substrate 52 are bonded by the first metal pad 63 and the second metal pad 68. In addition, the second wiring layer 65 and the fourth wiring layer 73 are arranged in a face to back (F to B) manner, and the second substrate 52 and the third substrate 53 are bonded by the third metal pad 71 and the fourth metal pad 75.

As illustrated in Fig. 6, a cross-sectional structure immediately below the pixel 15 is different from a cross-sectional structure of a region other than immediately below the pixel 15. A TSV 76 having a diameter larger than that of the TSV 70 in the pixel region is arranged from the second substrate 52 to the third substrate 53 in a region other than immediately below the pixel 15. The TSV 76 is for making a substrate contact, for example, and a predetermined reference voltage (for example, a power supply voltage or a ground voltage) is applied thereto.

Although not illustrated in Fig. 6, a reference contact for supplying a reference potential to at least one of the first substrate 51, the second substrate 52, and the third substrate 53 is provided. This reference contact is also referred to as a well contact.

Note that, in Fig. 6, the cross-sectional structure of the peripheral circuit of the pixel 15 is not illustrated on the first substrate 51 and the second substrate 52, but the peripheral circuit is arranged on, for example, the first substrate 51 or the second substrate 52 immediately above the TSV 76 as described later.

The peripheral circuit of the pixel 15 includes the vertical drive unit 12, the column signal processing unit 13, and the like of Fig. 2, and includes a plurality of transistors. Each transistor of the peripheral circuit is arranged in at least one free region of the first substrate 51, the second substrate 52, or the third substrate 53.

Fig. 7 is a cross-sectional view illustrating a first example of a cross-sectional structure of the peripheral circuit 55 of the pixel 15. In the first example, the peripheral circuit 55 of the pixel 15 is arranged on the second substrate 52. In this case, since it is not necessary to arrange the peripheral circuit 55 on the first substrate 51, for example, the number of pixels can be increased accordingly, and high resolution can be realized. Alternatively, the capacitances of the first capacitive element 31 and the second capacitive element 32 formed on the first substrate 51 can be increased, and the sensitivity can be improved.

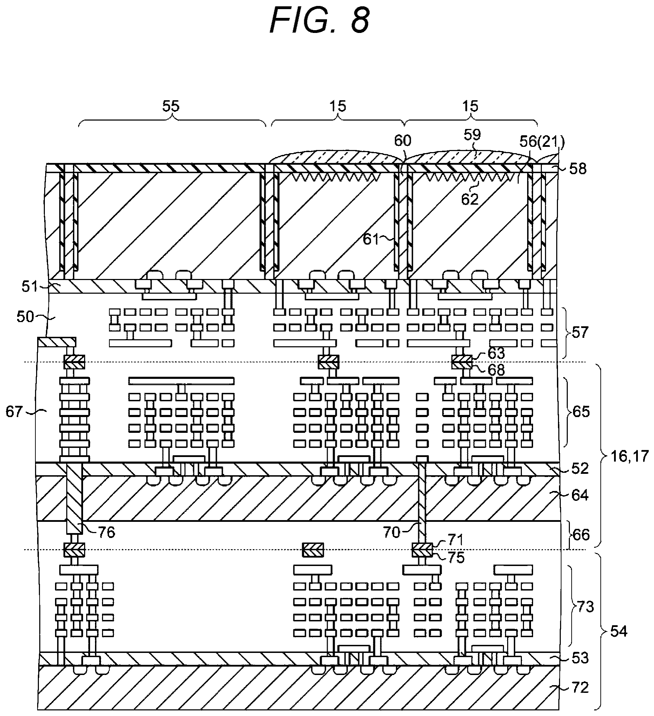

Fig. 8 is a cross-sectional view illustrating a second example of the cross-sectional structure of the peripheral circuit 55 of the pixel 15. In the second example, the peripheral circuit 55 of the pixel 15 is arranged separately on the first substrate 51 and the second substrate 52. By dispersedly arranging the peripheral circuit 55 on the first to third substrates 51 to 53, the element density of each substrate can be made uniform, and noise such as crosstalk can be easily suppressed. In Fig. 8, a bonding structure between the peripheral circuit 55 of the first substrate 51 and the peripheral circuit 55 of the second substrate 52 is not illustrated, but the above-described metal pads may be bonded to each other, or may be bonded by vias.

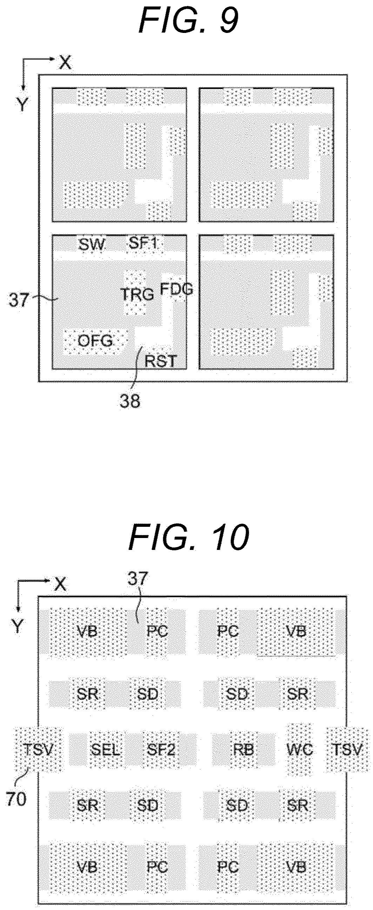

Fig. 9 is a planar layout diagram of 2×2 pixels of the first substrate 51 in a case where four pixels 15 and four first pixel circuits 16 share one second pixel circuit 17. In Fig. 9, a region of 2×2 pixels on the first substrate 51 and the second substrate 52 is referred to as a unit pixel group region. On the first substrate 51 and the second substrate 52, a plurality of unit pixel group regions is arranged in a two-dimensional direction. The four pixels 15 and the four first pixel circuits 16 sharing one second pixel circuit 17 may be, for example, a unit pixel group in a Bayer array. In this case, the unit pixel group may include four pixels 15 of red (R), green (G), blue (B), and green (G), or may include four pixels 15 of red (R), green (G), blue (B), and white (W).

In the example of the first substrate 51 of Fig. 9, a unit pixel group region including two pixels in each of the first direction X and the second direction Y is provided. In the first substrate 51, as illustrated in Fig. 9, a plurality of unit pixel group regions including four pixels 15 is arranged in a two-dimensional direction. In each unit pixel group region, the transfer transistor 22, the first reset transistor 23, the first source follower circuit 24, the first selection transistor 26, the discharge transistor 30, and the conversion efficiency switching transistor 27 are arranged. The photoelectric conversion element 21 is arranged in substantially the entire region of each pixel region below these transistors. More specifically, as illustrated in Fig. 9, in the unit pixel group region, a gate TRG of the transfer transistor 22, a gate RST of the first reset transistor 23, a gate SF1 of the first source follower circuit 24, a gate SW of the first selection transistor 26, a gate FDG of the conversion efficiency switching transistor 27, and a gate OFG of the discharge transistor 30 are arranged with a diffusion layer 37 interposed therebetween. An outlined portion of each pixel region is an insulating layer 38.

Fig. 10 is a plan layout diagram of a unit pixel group region of 2×2 pixels of the second substrate 52 laminated on the first substrate 51 of Fig. 8. On the second substrate 52, a plurality of unit pixel group regions is arranged in a two-dimensional direction. In each unit pixel group region, four first pixel circuits 16 and one second pixel circuit 17 are arranged. Furthermore, one TSV 70 is arranged in each unit pixel group region.

In the example of Fig. 10, in a region for four pixels along the first direction X, a first row in which two transistor groups 35 and 36 constituting the current source are arranged, a second row in which two sets each including the first sampling transistor 33 and the second sampling transistor 34 as one set are arranged, a third row in which the TSV 70, the second selection transistor 44, the second source follower circuit 42, the second reset transistor 41, and the well contact region are arranged, a fourth row in which two sets each including the first sampling transistor 33 and the second sampling transistor 34 as one set are arranged, and a fifth row in which two transistor groups 35 and 36 constituting the current source are arranged are arranged. In each row, the gate and the diffusion region of each transistor are arranged along the first direction X.

For example, in the first row and the fifth row, the gates VB, PC, PC, and VB of the two transistor groups 35 and 36 constituting the current source are arranged in this order along the first direction X with the diffusion layer 37 interposed between the gates. In the second row and the fourth row, the gates SR, SD, SR, and SD of the first and second sampling transistors 33 and 34 are arranged in this order along the first direction X with the diffusion layer 37 interposed between the gates. In the third row, the TSV 70, a gate SEL of the second selection transistor 44, a gate SF2 of the second source follower circuit 42, a gate RB of the second reset transistor 41, and a well contact region WC are arranged in this order along the first direction X with the diffusion layer 37 interposed between the gates.

In this manner, on the second substrate 52, the respective transistors and the like constituting the four first pixel circuits 16 and one second pixel circuit 17 are arranged symmetrically.

In particular, in the example of Fig. 10, the extending direction (hereinafter, simply referred to as a channel direction) of the channel of each transistor is the first direction X, and the diffusion layers 37 are arranged on both sides of the channel of each transistor in the second direction Y. As a result, the transistors adjacent to each other in the first direction X are arranged with the diffusion layers 37 therebetween, and it is possible to avoid the possibility that the channel is modulated due to the influence of the adjacent transistors.

In addition, the TSV 70 connected to the vertical signal line VSL is arranged on one axis (third row) extending in the first direction X together with the second selection transistor 44, the second source follower circuit 42, the second reset transistor 41, and the well contact region WC. As a result, the TSVs 70 are arranged with the diffusion layer 37 of the second selection transistor 44 adjacent in the first direction X therebetween, and it is possible to avoid the possibility that the channel of the second selection transistor 44 is modulated by the potential change of the TSV 70.

Note that the layout diagram of Fig. 10 is merely an example, and various modifications can be taken. For example, the TSV 70 may be arranged on one axis (second row or fourth row) with the first sampling transistor 33 and the second sampling transistor 34. Alternatively, the TSV 70 may be arranged on one axis (first row or fifth row) with the transistor groups 35 and 36 constituting the current source.

Furthermore, at least some of the transistors of Fig. 10 may be arranged point-symmetrically or line-symmetrically. For example, the gate SF2 of the second source follower circuit 42 may be arranged in the central portion of the unit pixel group region, and the gate SR of the first sampling transistor 33 for four pixels and the gate SD of the second sampling transistor 34 for four pixels may be arranged point-symmetrically or line-symmetrically with respect to the gate SF2. Consequently, the gate of the second source follower circuit 42 can equalize the influence of the crosstalk on the channel of the first sampling transistor 33 for four pixels and the channel of the second sampling transistor 34 for four pixels, and the image quality can be improved.

As described above, the first substrate 51 and the second substrate 52 transmit and receive signals by bonding (CCC: Copper-Copper Connection) of the first metal pad 63 and the second metal pad 68, and the second substrate 52 and the third substrate 53 transmit and receive signals by bonding the third metal pad 71 arranged at the end of the TSV 70 extending from the second substrate 52 to the third substrate 53 side and the fourth metal pad 75 of the third substrate 53. The arrangement positions and sizes of these metal pads are arbitrary.

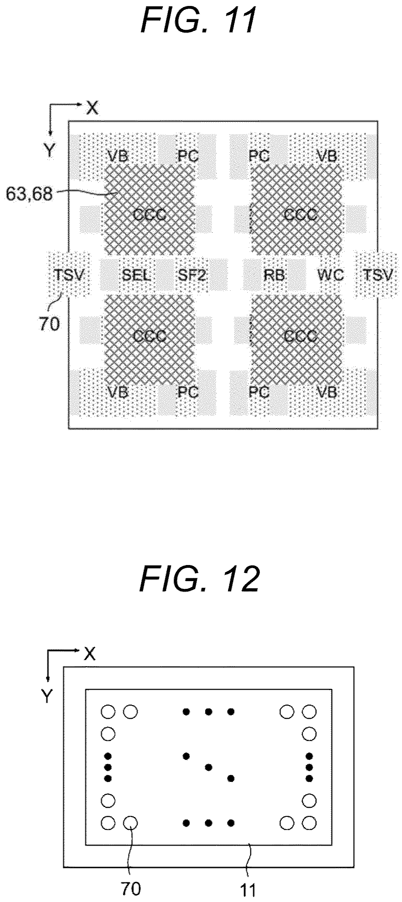

Fig. 11 is a plan layout diagram illustrating an example of bonding positions (CCC of Fig. 11) of the first metal pad 63 and the second metal pad 68 and arrangement positions of the TSVs 70 on the second substrate 52. While a bonding position between the first metal pad 63 and the second metal pad 68 is provided for each pixel 15, one TSV 70 is provided for each unit pixel group region including a plurality of (for example, four) pixels 15. Therefore, for example, as illustrated in Fig. 11, it is conceivable to arrange the bonding position between the first metal pad 63 and the second metal pad 68 at the central portion of each pixel region and arrange the TSV 70 at the central portion of the boundary side in the first direction X of the unit pixel group region. Fig. 11 is an example of arrangement positions and sizes of the first metal pad 63, the second metal pad 68, and the TSV 70, and various modifications can be taken.

As described above, since the TSV 70 extending from the second substrate 52 to the third substrate 53 is connected to the vertical signal lines VSL, the number of the TSVs is equal to the number of the vertical signal lines VSL. Several examples can be considered as arrangement positions of these TSVs 70.

Fig. 12 is a schematic plan layout diagram illustrating a first example of the arrangement positions of the TSVs 70. In the first example, the plurality of TSVs 70 is uniformly distributed over the entire pixel array unit 11.

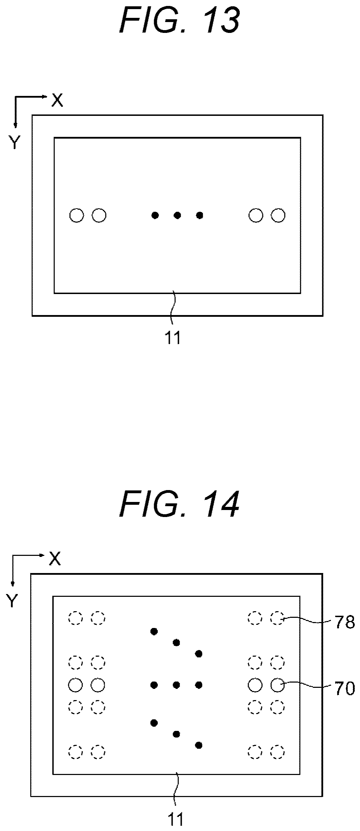

Fig. 13 is a schematic plan layout diagram illustrating a second example of the arrangement positions of the TSVs 70. As described above, the logic circuit 54 is arranged on the third substrate 53. The logic circuit 54 includes the column signal processing unit 13 of Fig. 1. The column signal processing unit 13 includes a plurality of analog-digital converters provided for each vertical signal line VSL. For example, the analog-digital converters are arranged along the first direction X at the central portion of the third substrate 53 in the second direction Y. Therefore, in the second example of Fig. 13, the plurality of TSVs 70 is arranged along the first direction X at the central portion of the pixel array unit 11 in the second direction Y in accordance with the arrangement positions of the analog-digital converters.

Fig. 14 is a schematic plan layout diagram illustrating a third example of the arrangement positions of the TSVs 70. In the third example, the TSVs 70 are uniformly arranged in the entire region of the pixel array unit 11, but the vias from the third wiring layer 66 are connected only to the plurality of TSVs 70 arranged along the first direction X in the central portion in the second direction Y. As a result, the plurality of TSVs 70 arranged in a portion other than the central portion in the second direction Y becomes dummy TSVs 78 that are not used for the purpose of transmitting pixel signals, and the pixel signals are electrically transmitted via the plurality of TSVs 70 arranged in the central portion in the second direction Y along the first direction X, similarly to Fig. 13.

The reason why the dummy TSVs 78 are provided as illustrated in Fig. 14 is that the plurality of TSVs 70 is uniformly arranged in the entire region of the pixel array unit 11, so that it is possible to suppress the fluctuation of the TSVs 70 on the characteristics of the surrounding transistors.

The first pixel circuit 16 of Fig. 3 includes two capacitive elements 31 and 32, but three or more capacitive elements may be provided. For example, by storing a voltage signal corresponding to signal charges in a plurality of capacitive elements and storing a voltage signal corresponding to a reset level in a plurality of capacitive elements, a voltage signal of a voltage level in a wider range can be held, and a dynamic range can be expanded.

Furthermore, when the accumulated charges of the photoelectric conversion element 21 are discharged via the discharge transistor 30, a charge holding unit that holds the discharged charges may be newly added, and the held charge of the charge holding unit may be transferred to the first floating diffusion region FD1 and used as a part of the signal charges.

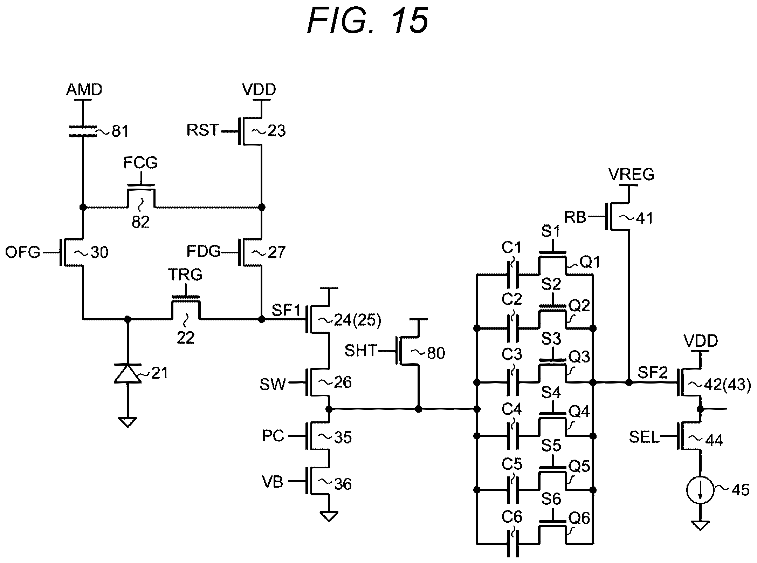

Fig. 15 is a circuit diagram illustrating a modification of the pixel 15 and the first pixel circuit 16 of Fig. 3. The pixel 15 illustrated in Fig. 15 includes a charge holding unit 81 and a new conversion efficiency switching transistor 82 in addition to the configuration of the pixel 15 of Fig. 3. The charge holding unit 81 is arranged between the drain of the discharge transistor 30 and the reference voltage node AMD. The new conversion efficiency switching transistor 82 is arranged between the drain of the discharge transistor 30 and the drain of the conversion efficiency transistor. The conversion efficiency switching transistor 82 is turned on when the FCG signal is at a high level, and transfers the held charge of the charge holding unit 81 to the first floating diffusion region SF1 via the conversion efficiency switching transistor 27.

The charge holding unit 81 is also called, for example, a lateral overflow integration capacitor (LOFIC). The charge holding unit 81 is, for example, a metal oxide semiconductor (MOS) capacitive element or a capacitive element having the above-described MIM structure.

The first pixel circuit 16 illustrated in Fig. 15 includes first to sixth capacitive elements C1 to C6, first to sixth sampling transistors Q1 to Q6, and a sample holding transistor 80. Among them, the first capacitive element C1 and the second capacitive element C2, and the first sampling transistor Q1 and the second sampling transistor Q2 are used to hold a voltage signal HCG equal to or larger than a first threshold. The third capacitive element C3 and the fourth capacitive element C4, and the third sampling transistor Q3 and the fourth sampling transistor Q4 are used to hold a voltage signal MCG less than the first threshold and equal to or greater than a second threshold. The fifth capacitive element C5 and the sixth capacitive element C6, and the fifth sampling transistor Q5 and the sixth sampling transistor Q6 are used to hold a voltage signal LCG less than the second threshold.

Note that the numbers of the capacitive elements and the sampling transistors are arbitrary, and are not limited to those illustrated in Figs. 3 and 15.

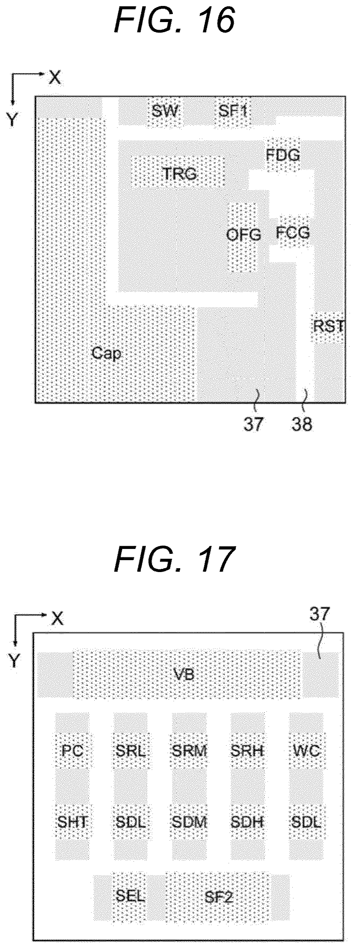

Fig. 16 is a plan layout diagram of the first substrate 51 corresponding to Fig. 15. The charge holding unit 81 illustrated in Fig. 15 is arranged, for example, at a position overlapping the photoelectric conversion element 21 in the depth direction, and the charge holding unit 81 can be arranged without reducing the area of the photoelectric conversion element 21. In Fig. 16, the arrangement region of the charge holding unit 81 is denoted as Cap.

Fig. 17 is a plan layout diagram of the second substrate 52 corresponding to Fig. 15. On the second substrate 52, a first row in which the gate VB of the transistor constituting the current source is arranged along the first direction X, a second row in which the gate SF2 of the second source follower circuit 42 in the second pixel circuit 17 and the gate SEL of the second selection transistor 44 are arranged along the second direction Y, and a first column to a fifth column arranged between the first row and the second row are arranged.

In the first column, a gate PC of a transistor constituting a current source and a gate SHT of a third amplification transistor are arranged along the second direction Y. In the second column, gates SRL and SDL of the fifth and sixth sampling transistors Q5 and Q6 are arranged along the second direction Y. In the third column, gates SRM and SDM of the third and fourth sampling transistors are arranged along the second direction Y. In the fourth column, gates SRH and SDH of the first and second sampling transistors are arranged along the second direction Y. In the fifth column, the well contact region WC and the gate RB of the second reset transistor 41 are arranged along the second direction Y.

Specific circuit configurations of the pixel 15 and the pixel circuit are not limited to the circuit configuration illustrated in Fig. 3 or Fig. 15, and various circuit configurations can be applied.

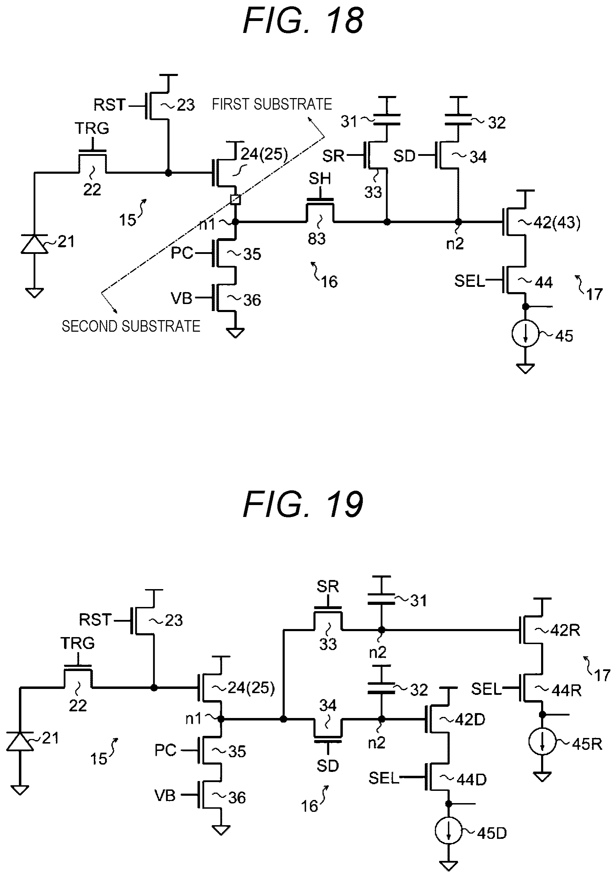

Fig. 18 is a circuit diagram of a pixel 15, a first pixel circuit 16, and a second pixel circuit 17 according to a first modification. Fig. 18 is different from Figs. 3 and 15 in the circuit configuration of the first pixel circuit 16. Note that although the discharge transistor 30 and the conversion efficiency switching transistor 27 in the pixel 15 are omitted in Fig. 18, these transistors may be provided, and the configuration of the pixel 15 is substantially the same as that in Fig. 3.

The first pixel circuit 16 of Fig. 18 includes a sample holding transistor 83 in addition to the first capacitive element 31 and the second capacitive element 32, the first sampling transistor 33 and the second sampling transistor 34, and the transistor groups 35 and 36 constituting the current source.

The sample holding transistor 83 is connected between the output node n1 of the pixel 15 and the output node n2 of the first pixel circuit 16. The first capacitive element 31 and the first sampling transistor 33 are connected in series between a reference voltage node (for example, a power supply voltage node) and the output node n2 of the first pixel circuit 16. The second capacitive element 32 and the second sampling transistor 34 are connected in series between the reference voltage node and the output node n2 of the first pixel circuit 16.

Fig. 19 is a circuit diagram of a pixel 15, a first pixel circuit 16, and a second pixel circuit 17 according to a second modification. Fig. 19 includes the pixel 15 having substantially the same circuit configuration as that of Fig. 3 and the first pixel circuit 16 having a circuit configuration different from that of Fig. 3.

The first pixel circuit 16 of Fig. 19 has a first output node SF21 and a second output node SF22, and the second pixel circuit 17 is separately connected to each of them. One transistor (not illustrated) may be added separately, and only one second pixel circuit 17 may be provided, so that the first output node SF21 or the second output node SF22 is selected by the added transistor and connected to the second pixel circuit 17. One second pixel circuit 17 includes a second source follower circuit 42R and a second selection transistor 44R, and the other second pixel circuit 17 includes a second source follower circuit 42D and a second selection transistor 44D.

The first pixel circuit 16 of Fig. 19 includes a transistor that is connected to the output node n1 of the pixel 15 and constitutes a current source, the first sampling transistor 33 and the first capacitive element 31, and the second sampling transistor 34 and the second capacitive element 32. The first capacitive element 31 is connected between the reference voltage node and the first output node SF21. The first sampling transistor 33 is connected between the first output node SF21 and the output node n1 of the pixel 15. The second capacitive element 32 is connected between the reference voltage node and the second output node SF22. The second sampling transistor 34 is connected between the second output node SF22 and the output node n1 of the pixel 15.

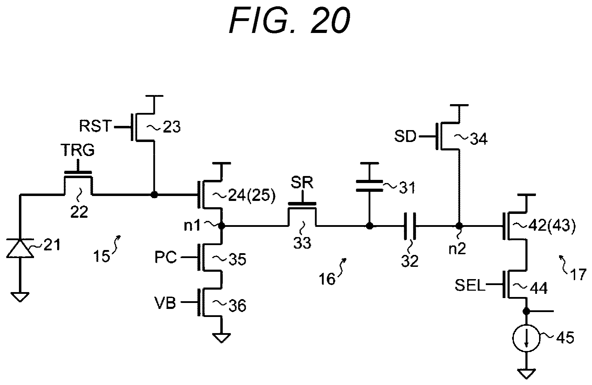

Fig. 20 is a circuit diagram of a pixel 15, a first pixel circuit 16, and a second pixel circuit 17 according to a third modification. Fig. 20 includes the pixel 15 having substantially the same circuit configuration as that of Fig. 3 and the first pixel circuit 16 having a circuit configuration different from that of Fig. 3.

The first pixel circuit 16 of Fig. 20 includes the first and second sampling transistors 33 and 34, the first capacitive element 31 and the second capacitive element 32, and the transistor groups 35 and 36 constituting the current source.

The first sampling transistor 33 and the second capacitive element 32 are connected in series between the output node n1 of the pixel 15 and the output node n2 of the first pixel circuit 16. The first capacitive element 31 is connected between a reference voltage node (for example, a power supply voltage node) and the output node n2 of the first pixel circuit 16. The second sampling transistor 34 is connected between the reference voltage node and the output node of the first pixel circuit 16.

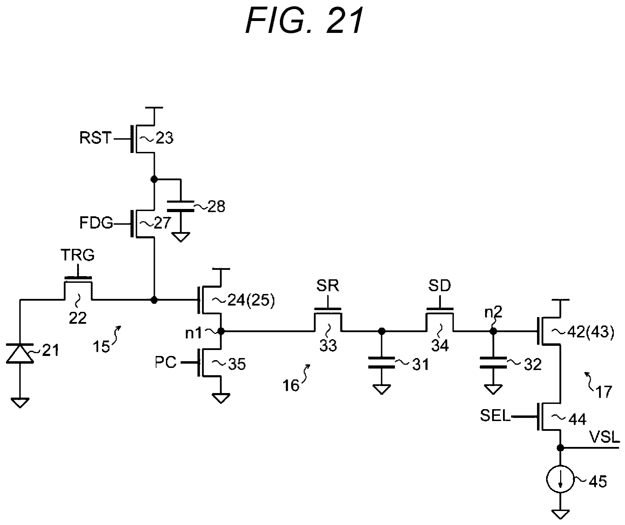

Fig. 21 is a circuit diagram of a pixel 15, a first pixel circuit 16, and a second pixel circuit 17 according to a fourth modification. Fig. 21 includes the pixel 15 having a circuit configuration substantially the same as that in Fig. 3, and the first pixel circuit 16 and the second pixel circuit 17 having a circuit configuration different from that in Fig. 3.

The first pixel circuit 16 of Fig. 21 includes the transistor 35 constituting the current source connected between the output node n1 of the pixel 15 and a reference voltage node (for example, a ground node), the first sampling transistor 33 and the second sampling transistor 34 cascode-connected between the output node n1 of the pixel 15 and the output node n2 of the first pixel circuit 16, the first capacitive element 31 connected between a connection node of the first sampling transistor 33 and the second sampling transistor 34 and a reference voltage node (for example, a ground node), and the second capacitive element 32 connected between the output node n2 of the first pixel circuit 16 and the reference voltage node (for example, a ground node).

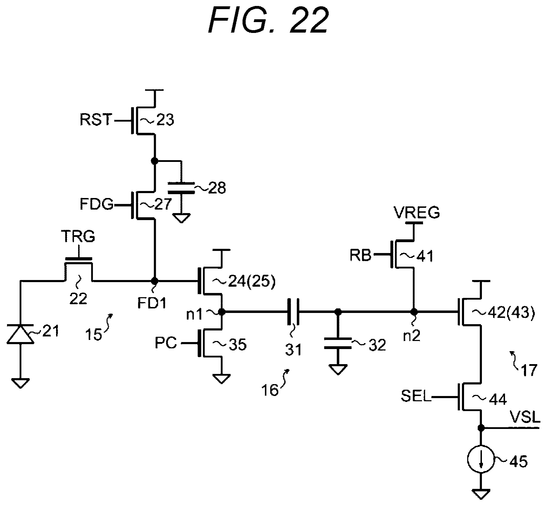

The second pixel circuit 17 of Fig. 21 includes the second source follower circuit 42 (second amplification transistor 43) and the second selection transistor 44 cascode-connected between a reference voltage node (for example, a power supply voltage node) and the vertical signal line VSL. The second pixel circuit 17 of Fig. 22 does not have the second sampling transistor 34 of Fig. 3, but the second sampling transistor 34 may be added.

Fig. 22 is a circuit diagram of a pixel 15, a first pixel circuit 16, and a second pixel circuit 17 according to a fifth modification. Fig. 21 includes the pixel 15 having substantially the same circuit configuration as that of Fig. 3 and the first pixel circuit 16 having a circuit configuration different from that of Fig. 3.

The first pixel circuit 16 of Fig. 22 includes the transistor 35 constituting the current source connected between the output node n1 of the pixel 15 and a reference voltage node (for example, a ground node), the first capacitive element 31 connected between the output node n1 of the pixel 15 and the output node n2 of the first pixel circuit 16, and the second capacitive element 32 connected between the output node n2 of the first pixel circuit 16 and the reference voltage node (for example, a ground node).

The first pixel circuit 16 according to Fig. 3 and the first to fifth modifications described above includes the current source connected between the output node n1 of the pixel 15 and a reference voltage node (for example, a ground node), but the current source may be configured by the transistor groups 35 and 36 or may be configured by a single transistor 35. Furthermore, whether or not to provide the conversion efficiency switching transistor 27 and the discharge transistor 30 in the pixel 15 is also arbitrary.

As described above, in the present embodiment, since the global shutter type photodetection device 3 that converts the photoelectrically converted charge into the voltage signal and then holds the voltage signal has the laminated structure of the first to third substrates 51 to 53, it is possible to give a margin to the area of the pixel 15 and the pixel circuit, to increase the number of pixels and to achieve high resolution, to secure the first capacitive element 31 and the second capacitive element 32 having sufficient capacitance to hold the voltage signal, and to expand the dynamic range.

In addition, since the first substrate 51 and the second substrate 52 perform signal transmission by bonding metal pads to each other, and the second substrate 52 and the third substrate 53 perform signal transmission by bonding metal pads each arranged at the end of the TSV 70 penetrating the semiconductor layer on the second substrate 52 to each other, signal transmission can be efficiently performed between the substrates, and the laminated chip can be downsized.

< Application Example to Mobile Body > The technology according to the present disclosure (present technology) can be applied to various products. For example, the technology according to the present disclosure may also be implemented as a device mounted on any type of mobile body such as an automobile, an electric automobile, a hybrid electric automobile, a motorcycle, a bicycle, a personal mobility, an airplane, a drone, a ship, and a robot.

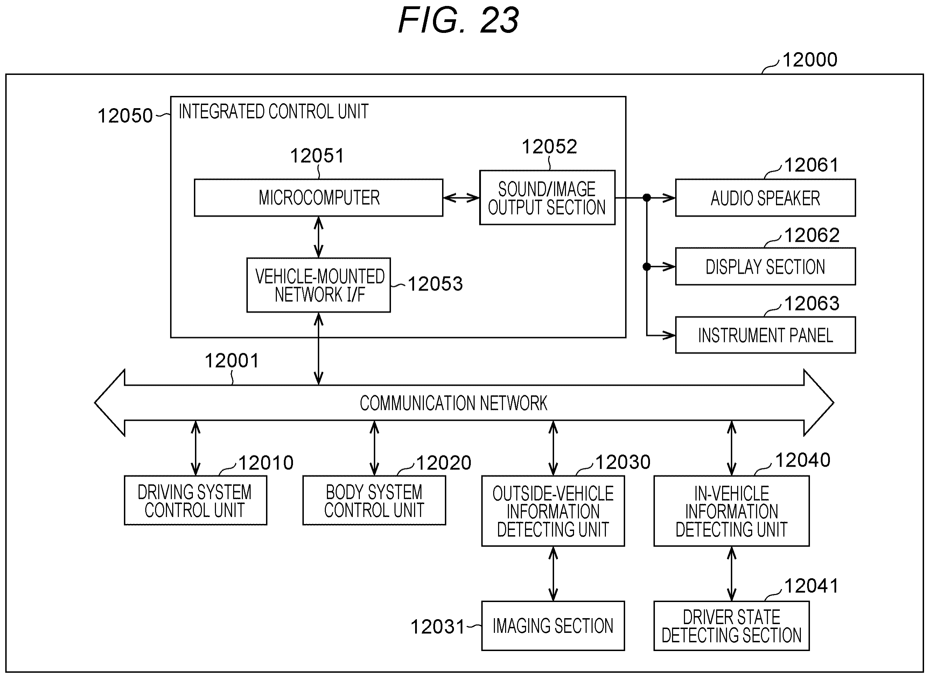

Fig. 23 is a block diagram illustrating a schematic configuration example of a vehicle control system which is an example of a mobile body control system to which the technology according to the present disclosure can be applied.

The vehicle control system 12000 includes a plurality of electronic control units connected to each other via a communication network 12001. In the example illustrated in Fig. 23, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 23, an audio speaker 12061, a display section 12062, and an instrument panel 12063 are illustrated as the output device. The display section 12062 may, for example, include at least one of an on-board display and a head-up display.

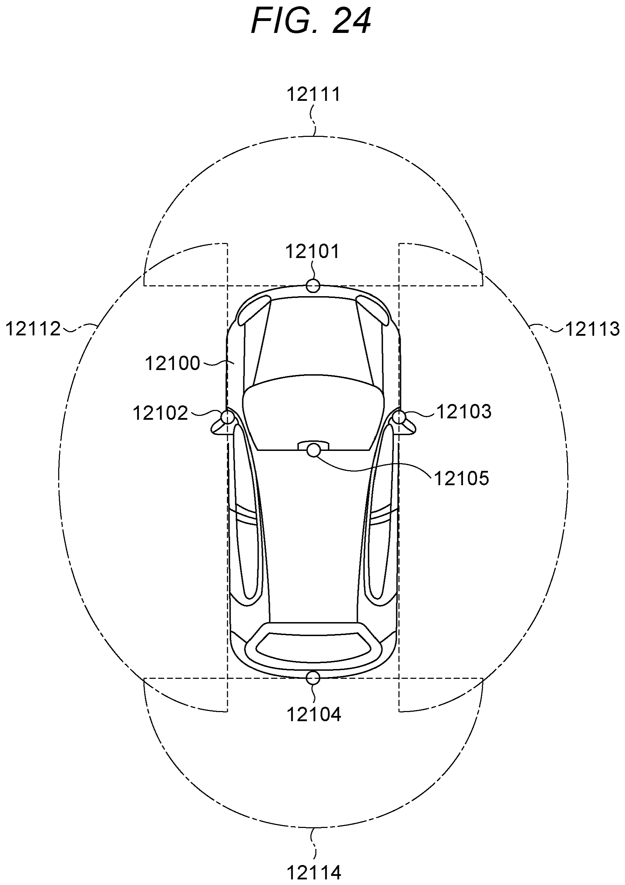

Fig. 24 is a diagram illustrating an example of the installation position of the imaging section 12031.

In Fig. 24, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 24 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 and the like, for example, among the configurations described above. Specifically, the photodetection device 3 according to the present embodiment can be applied to the imaging section 12031." and the like). By applying the technology according to the present disclosure to the imaging section 12031, a more easily viewable captured image can be obtained, by which fatigue of the driver can be reduced.

< Application Example to Endoscopic Surgical System > The technology according to the present disclosure (present technology) can be applied to various products. For example, the technology according to the present disclosure may be applied to an endoscopic surgery system.

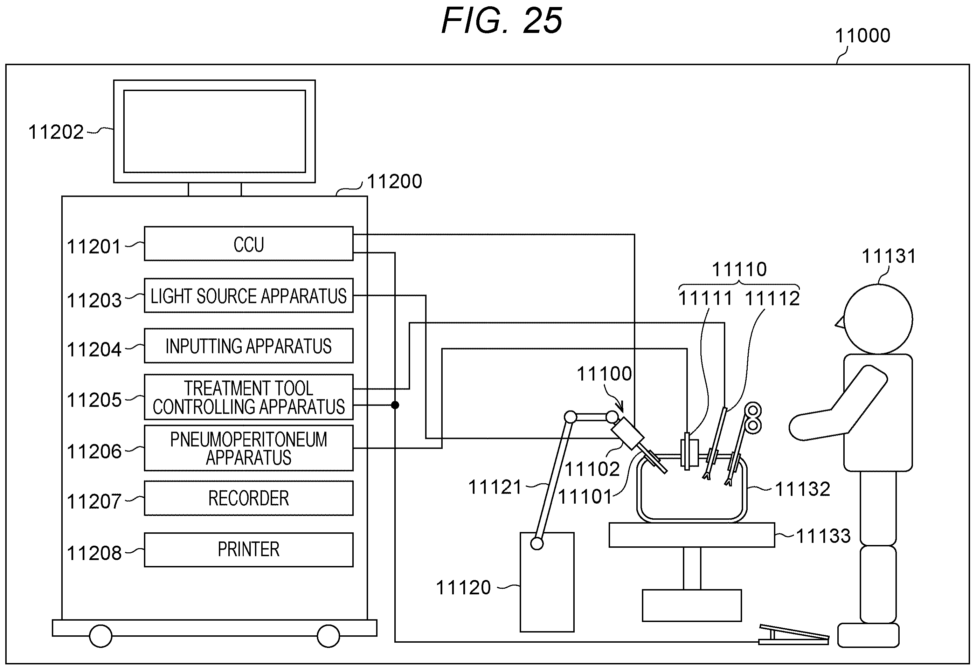

Fig. 25 is a diagram illustrating an example of a schematic configuration of an endoscopic surgery system to which the technology according to the present disclosure (present technology) can be applied.

In Fig. 25, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

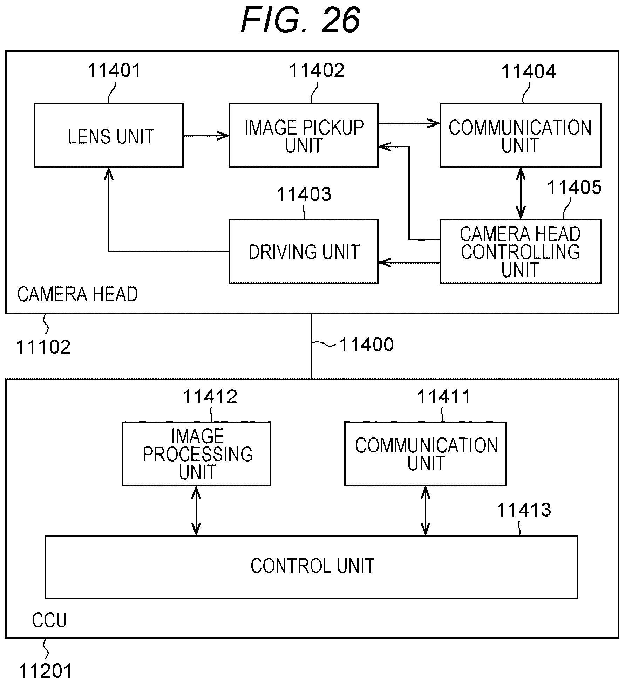

Fig. 26 is a block diagram illustrating an example of a functional configuration of the camera head 11102 and the CCU 11201 illustrated in Fig. 25.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been described above. The technology according to the present disclosure can be applied to, for example, the endoscope 11100, (the imaging unit 11402 of) the camera head 11102, (the image processing unit 11412 of) the CCU 11201, and the like) among the configurations described above. Specifically, the photodetection device 3 according to the present embodiment can be applied to the imaging unit 10402. By applying the technology according to the present disclosure to the imaging unit 10402, for example, a clearer image of an operative site can be obtained, so that the operator can reliably check the surgical site.

Note that an endoscopic surgery system has been described as an example herein, but the technology according to the present disclosure may be applied to a microscopic surgery system or the like, for example.

Note that the present technology may have the following configurations.
(1) A photodetection device including:
   a plurality of pixels each of which accumulates a charge corresponding to a light amount of incident light;
   a plurality of first pixel circuits each of which includes a plurality of capacitive elements that holds a voltage signal corresponding to a charge accumulated in the plurality of pixels at the same timing;
   a plurality of second pixel circuits that is shared by two or more of the first pixel circuits among the plurality of first pixel circuits and sequentially reads out charges held in two or more of the capacitive elements in the two or more of the first pixel circuits to generate a pixel signal;
   a logic circuit that performs a signal process on a plurality of the pixel signals generated in the plurality of second pixel circuits;
   a first substrate on which the plurality of pixels is arranged;
   a second substrate which is laminated on the first substrate and on which the plurality of first pixel circuits and the plurality of second pixel circuits are arranged; and
   a third substrate which is laminated on the second substrate and on which the logic circuit is arranged.
(2) The photodetection device according to (1), in which
   a first wiring layer connected to the plurality of pixels in the first substrate and a second wiring layer connected to the plurality of first pixel circuits and the plurality of second pixel circuits in the second substrate are arranged to face each other, and
   the second wiring layer in the second substrate and a third wiring layer connected to the logic circuit in the third substrate are arranged with the second substrate interposed therebetween.
(3) The photodetection device according to (1) or (2), in which
   the first substrate includes a plurality of first metal pads bonded to the first wiring layer, and
   the second substrate includes a plurality of second metal pads bonded to the plurality of first metal pads and bonded to the second wiring layer.
(4) The photodetection device according to any one of (1) to (3), in which
   the second substrate includes:
   a semiconductor layer arranged to face the third substrate;
   a plurality of first vias arranged so as to penetrate the semiconductor layer from the plurality of second pixel circuits; and
   a plurality of third metal pads bonded to ends of the plurality of first vias, respectively, and
   the third substrate includes a plurality of fourth metal pads bonded to the plurality of third metal pads.
(5) The photodetection device according to (4), in which
   the plurality of first vias is connected to a plurality of signal lines for transmitting the plurality of pixel signals generated by the plurality of second pixel circuits to the logic circuit.
(6) The photodetection device according to (4) or (5), in which
   the plurality of first vias is arranged over an entire region of the second substrate.
(7) The photodetection device according to (4) or (5), in which
   the second substrate includes a plurality of signal lines that transmits the plurality of pixel signals generated by the plurality of second pixel circuits,
   the plurality of signal lines is arranged in a first direction of the second substrate and each extends in a second direction intersecting the first direction,
   the logic circuit includes an analog-digital converter that is arranged in a central portion of the third substrate in the second direction and performs analog-digital conversion of the pixel signals, and
   at least a part of the plurality of first vias is arranged in a central portion of the second substrate in the second direction in accordance with an arrangement region of the analog-digital converter in the third substrate and is connected to the plurality of signal lines.
(8) The photodetection device according to (7), in which
   the plurality of first vias is arranged over an entire region of the second substrate, and
   a first via arranged at a position other than the central portion of the second substrate in the second direction is a dummy via that does not transmit a signal.
(9) The photodetection device according to any one of (4) to (8), in which
   the plurality of first vias is arranged one by one for each of the two or more pixels, and
   the third metal pad and the fourth metal pad are provided for each of the two or more pixels.
(10) The photodetection device according to any one of (1) to (9), in which
   the second substrate includes a first peripheral circuit arranged in a region not overlapping the plurality of pixels in a plan view of the first substrate and the second substrate.
(11) The photodetection device according to any one of (1) to (10), in which
   the first substrate includes a second peripheral circuit arranged in a region where the plurality of pixels is not arranged.
(12) The photodetection device according to any one of (1) to (11), in which
   each of the plurality of pixels includes:
   a photoelectric conversion element that accumulates a charge corresponding to a light amount of incident light;
   a first transistor that switches whether or not to transfer the accumulated charge of the photoelectric conversion element to a first floating diffusion region;
   a second transistor that switches whether or not to initialize the charge of the first floating diffusion region; and
   a first source follower circuit that generates a voltage signal corresponding to the charge of the first floating diffusion region,
   each of the plurality of first pixel circuits includes:
      a first capacitive element that holds a voltage signal output from the first source follower circuit in a state where the charge of the first floating diffusion region of the corresponding pixel is initialized;
      a second capacitive element that holds a voltage signal output from the first source follower circuit in a state where the accumulated charge of the photoelectric conversion element is transferred to the first floating diffusion region of the corresponding pixel;
      a third transistor that switches whether or not to transfer a charge held in the first capacitive element to a second floating diffusion region shared by the two or more first pixel circuits; and
      a fourth transistor that switches whether or not to transfer a charge held in the second capacitive element to the second floating diffusion region, and
      each of the plurality of second pixel circuits includes:
         a fifth transistor that switches whether or not to initialize the charge of the second floating diffusion region; and
         a second source follower circuit that generates a pixel signal according to the charge of the second floating diffusion region.
(13) The photodetection device according to
   (12), in which
   each of the plurality of pixels includes
   a third capacitance element that stores a part of the stored charge of the photoelectric conversion element, and
   a sixth transistor that switches whether or not to store a part of the stored charge of the photoelectric conversion element in the third capacitance element.
(14) The photodetection device according to
   (12) or (13), in which
   each of the plurality of pixels includes a seventh transistor that switches whether or not to discharge the accumulated charge of the photoelectric conversion element.
(15) The photodetection device according to
   (14), further including: a fourth capacitive element that holds the accumulated charge of the photoelectric conversion element discharged via the seventh transistor; and an eighth transistor that switches whether or not to transfer the charge held in the fourth capacitive element to the first floating diffusion region.
(16) The photodetection device according to
   (15), in which
   the fourth capacitive element is arranged on the first substrate.
(17) The photodetection device according to any one of (12) to (16), in which
   each of the plurality of first pixel circuits includes
   a ninth transistor and a tenth transistor cascode-connected between an output node of the first source follower circuit and a reference voltage node, and
   the ninth transistor and the tenth transistor are turned on at different timings to precharge the first capacitive element and the second capacitive element.
(18) The photodetection device according to any one of (12) to (17), further including:
   a plurality of first holding circuits each including the first capacitive element and the third transistor and connected in parallel; and
   a plurality of second holding circuits each including the second capacitive element and the fourth transistor and connected in parallel.
(19) The photodetection device according to any one of
   (1) to (18), further including a substrate contact that supplies a reference potential to at least one of the first substrate, the second substrate, or the third substrate.
(20) An electronic device including:
   a photodetection device that generates an image according to a light amount of incident light; and
   a processing unit that processes the image,
   the photodetection device including:
      a plurality of pixels each of which accumulates a charge corresponding to a light amount of incident light;
      a plurality of first pixel circuits each of which includes a plurality of capacitive elements that holds a voltage signal corresponding to a charge accumulated in the plurality of pixels at the same timing;
      a plurality of second pixel circuits that is shared by two or more of the first pixel circuits among the plurality of first pixel circuits and sequentially reads out charges held in two or more of the capacitive elements in the two or more of the first pixel circuits to generate a pixel signal;
      a logic circuit that performs a signal process on a plurality of the pixel signals generated in the plurality of second pixel circuits;
      a first substrate on which the plurality of pixels is arranged;
      a second substrate which is laminated on the first substrate and on which the plurality of first pixel circuits and the plurality of second pixel circuits are arranged; and
      a third substrate which is laminated on the second substrate and on which the logic circuit is arranged.

Modes of the present disclosure are not limited to the individual embodiments described above, but include various modifications that may be conceived by those skilled in the art, and the effects of the present disclosure are not limited to the contents described above. That is, various additions, modifications, and partial deletions may be made without departing from the conceptual idea and spirit of the present disclosure derived from the matters defined in the claims and equivalents thereof.

### REFERENCE SIGNS LIST

- 1: Electronic device
- 2: Imaging lens
- 3: Photodetection device
- 3: Photodetection device according to embodiment
- 4: Image processing unit
- 5: Recording unit
- 6: Control unit
- 11: Pixel array unit
- 12: Vertical drive unit
- 13: And column signal processing unit
- 13: Column signal processing unit
- 14: Timing control unit
- 15: Pixel
- 16: First pixel circuit
- 17: Second pixel circuit
- 21: Photoelectric conversion element
- 22: Transfer transistor
- 23: First reset transistor
- 24: First source follower circuit
- 25: First amplification transistor
- 26: First selection transistor
- 27: Conversion efficiency switching transistor
- 28: Charge holding unit
- 29: Voltage switcher
- 30: Discharge transistor
- 31: First capacitive element
- 32: Second capacitive element
- 33: First sampling transistor
- 34: Second sampling transistor
- 35: Transistor group
- 36: Transistor group
- 37: Diffusion layer
- 41: Second reset transistor
- 42: Second source follower circuit
- 43: Second amplification transistor
- 44: Second selection transistor
- 45: Current source
- 50: First insulating layer
- 51: First substrate
- 52: Second substrate
- 53: Third substrate
- 54: Logic circuit
- 55: Peripheral circuit
- 56: First semiconductor layer
- 57: First wiring layer
- 58: Color filter
- 59: On-chip lens
- 60: Light shielding wall
- 61: Fixed charge film
- 62: Uneven structure
- 63: First metal pad
- 64: Second semiconductor layer
- 65: Second wiring layer
- 66: Third wiring layer
- 67: Second insulating layer
- 68: Second metal pad
- 70: Penetrating via
- 71: Third metal pad
- 72: Third semiconductor layer
- 73: Fourth wiring layer
- 73: Third insulating layer
- 75: Fourth metal pad
- 80: Sample holding transistor
- 81: Charge holding unit
- 82: Conversion efficiency switching transistor
- 83: Sample holding transistor

## Claims

1. A photodetection device comprising:
a plurality of pixels each of which accumulates a charge corresponding to a light amount of incident light;
a plurality of first pixel circuits each of which includes a plurality of capacitive elements that holds a voltage signal corresponding to a charge accumulated in the plurality of pixels at the same timing;
a plurality of second pixel circuits that is shared by two or more of the first pixel circuits among the plurality of first pixel circuits and sequentially reads out charges held in two or more of the capacitive elements in the two or more of the first pixel circuits to generate a pixel signal;
a logic circuit that performs a signal process on a plurality of the pixel signals generated in the plurality of second pixel circuits;
a first substrate on which the plurality of pixels is arranged;
a second substrate which is laminated on the first substrate and on which the plurality of first pixel circuits and the plurality of second pixel circuits are arranged; and
a third substrate which is laminated on the second substrate and on which the logic circuit is arranged.

2. The photodetection device according to claim 1, wherein
a first wiring layer connected to the plurality of pixels in the first substrate and a second wiring layer connected to the plurality of first pixel circuits and the plurality of second pixel circuits in the second substrate are arranged to face each other, and
the second wiring layer in the second substrate and a third wiring layer connected to the logic circuit in the third substrate are arranged with the second substrate interposed therebetween.

3. The photodetection device according to claim 2, wherein
the first substrate includes a plurality of first metal pads bonded to the first wiring layer, and
the second substrate includes a plurality of second metal pads bonded to the plurality of first metal pads and bonded to the second wiring layer.

4. The photodetection device according to claim 1, wherein
the second substrate includes:
a semiconductor layer arranged to face the third substrate;
a plurality of first vias arranged so as to penetrate the semiconductor layer from the plurality of second pixel circuits; and
a plurality of third metal pads bonded to ends of the plurality of first vias, respectively, and
the third substrate includes a plurality of fourth metal pads bonded to the plurality of third metal pads.

5. The photodetection device according to claim 4, wherein
the plurality of first vias is connected to a plurality of signal lines for transmitting the plurality of pixel signals generated by the plurality of second pixel circuits to the logic circuit.

6. The photodetection device according to claim 4, wherein
the plurality of first vias is arranged over an entire region of the second substrate.

7. The photodetection device according to claim 4, wherein
the second substrate includes a plurality of signal lines that transmits the plurality of pixel signals generated by the plurality of second pixel circuits,
the plurality of signal lines is arranged in a first direction of the second substrate and each extends in a second direction intersecting the first direction,
the logic circuit includes an analog-digital converter that is arranged in a central portion of the third substrate in the second direction and performs analog-digital conversion of the pixel signals, and
at least a part of the plurality of first vias is arranged in a central portion of the second substrate in the second direction in accordance with an arrangement region of the analog-digital converter in the third substrate and is connected to the plurality of signal lines.

8. The photodetection device according to claim 7, wherein
the plurality of first vias is arranged over an entire region of the second substrate, and
a first via arranged at a position other than the central portion of the second substrate in the second direction is a dummy via that does not transmit a signal.

9. The photodetection device according to claim 4, wherein
the plurality of first vias is arranged one by one for each of the two or more pixels, and
the third metal pad and the fourth metal pad are provided for each of the two or more pixels.

10. The photodetection device according to claim 1, wherein
the second substrate includes a first peripheral circuit arranged in a region not overlapping the plurality of pixels in a plan view of the first substrate and the second substrate.

11. The photodetection device according to claim 1, wherein
the first substrate includes a second peripheral circuit arranged in a region where the plurality of pixels is not arranged.

12. The photodetection device according to claim 1, wherein
each of the plurality of pixels includes:
a photoelectric conversion element that accumulates a charge corresponding to a light amount of incident light;
a first transistor that switches whether or not to transfer the accumulated charge of the photoelectric conversion element to a first floating diffusion region;
a second transistor that switches whether or not to initialize the charge of the first floating diffusion region; and
a first source follower circuit that generates a voltage signal corresponding to the charge of the first floating diffusion region,
each of the plurality of first pixel circuits includes:
a first capacitive element that holds a voltage signal output from the first source follower circuit in a state where the charge of the first floating diffusion region of the corresponding pixel is initialized;
a second capacitive element that holds a voltage signal output from the first source follower circuit in a state where the accumulated charge of the photoelectric conversion element is transferred to the first floating diffusion region of the corresponding pixel;
a third transistor that switches whether or not to transfer a charge held in the first capacitive element to a second floating diffusion region shared by the two or more first pixel circuits; and
a fourth transistor that switches whether or not to transfer a charge held in the second capacitive element to the second floating diffusion region, and
each of the plurality of second pixel circuits includes:
a fifth transistor that switches whether or not to initialize the charge of the second floating diffusion region; and
a second source follower circuit that generates a pixel signal according to the charge of the second floating diffusion region.

13. The photodetection device according to claim 12, wherein
each of the plurality of pixels includes:
a third capacitance element that accumulates a part of the accumulated charge of the photoelectric conversion element; and
a sixth transistor that switches whether or not to accumulate a part of the accumulated charge of the photoelectric conversion element in the third capacitance element.

14. The photodetection device according to claim 12 or 13, wherein each of the plurality of pixels includes a seventh transistor that switches whether or not to discharge the accumulated charge of the photoelectric conversion element.

15. The photodetection device according to claim 14, further comprising:
a fourth capacitive element that holds the accumulated charge of the photoelectric conversion element discharged via the seventh transistor; and
an eighth transistor that switches whether or not to transfer the charge held in the fourth capacitive element to the first floating diffusion region.

16. The photodetection device according to claim 15, wherein
the fourth capacitive element is arranged on the first substrate.

17. The photodetection device according to claim 12, wherein
each of the plurality of first pixel circuits includes
a ninth transistor and a tenth transistor cascode-connected between an output node of the first source follower circuit and a reference voltage node, and
the ninth transistor and the tenth transistor are turned on at different timings to precharge the first capacitive element and the second capacitive element.

18. The photodetection device according to claim 12, further comprising:
a plurality of first holding circuits each including the first capacitive element and the third transistor and connected in parallel; and
a plurality of second holding circuits each including the second capacitive element and the fourth transistor and connected in parallel.

19. The photodetection device according to claim 1, further comprising a substrate contact that supplies a reference potential to at least one of the first substrate, the second substrate, or the third substrate.

20. An electronic device comprising:
a photodetection device that generates an image according to a light amount of incident light; and
a processing unit that processes the image,
the photodetection device including:
a plurality of pixels each of which accumulates a charge corresponding to a light amount of incident light;
a plurality of first pixel circuits each of which includes a plurality of capacitive elements that holds a voltage signal corresponding to a charge accumulated in the plurality of pixels at the same timing;
a plurality of second pixel circuits that is shared by two or more of the first pixel circuits among the plurality of first pixel circuits and sequentially reads out charges held in two or more of the capacitive elements in the two or more of the first pixel circuits to generate a pixel signal;
a logic circuit that performs a signal process on a plurality of the pixel signals generated in the plurality of second pixel circuits;
a first substrate on which the plurality of pixels is arranged;
a second substrate which is laminated on the first substrate and on which the plurality of first pixel circuits and the plurality of second pixel circuits are arranged; and
a third substrate which is laminated on the second substrate and on which the logic circuit is arranged.
